# EUROPEAN PATENT APPLICATION

(11) **EP 4 570 875 A1**
(43) Date of publication of application: **18.06.2025**
(21) Application number: 23852530.7
(22) Date of filing: 07.08.2023
(51) Int. Cl.: C09J 129/14, C09J 11/06, G06F 3/041

(54) **INTERLAYER ADHESIVE, INTERLAYER ADHESIVE FOR TOUCH PANEL, AND TOUCH PANEL**

(30) Priority: 08.08.2022 JP 2022126648
(71) Applicant: SEKISUI CHEMICAL CO., LTD., Osaka-shi Osaka 530-8565 (JP)
(72) Inventor: OKAZAWA, Shingo, 6045JB Roermond (NL); NOHARA, Atsushi, Koka-shi, Shiga 528-8585 (JP); HAGIWARA, Yusuke, Koka-shi, Shiga 528-8585 (JP)
(74) Representative: Ter Meer Steinmeister & Partner
(86) International application number: PCT/JP2023/028762
(87) International publication number: WO 2024/034568

(57) **Abstract**

The interlayer adhesive of the present invention consists of a resin layer that comprises a polyvinyl acetal resin, and a content of alkali metal and alkaline earth metal contained in the resin layer is 15 ppm or less. According to the present invention, an interlayer adhesive comprising a polyvinyl acetal resin and capable of suppressing whitening can be provided.

## Description

### Technical Field

The present invention relates to an interlayer adhesive, an interlayer adhesive for a touch panel, and a touch panel.

### Background Art

In recent years, a touch panel capable of inputting information by touching with fingers is sometimes disposed in personal digital assistants, such as smartphones and tablets, displays for vehicles, etc.

In a touch panel, a multilayer structure is formed of members, such as a cover glass, a sensor glass, and a liquid crystal panel. Then, enhancement in visibility has been carried out by filling interlayer spaces between the members with a filling material and thereby enhancing transparency, brightness, contrast, and the like of a display screen.

For example, in Patent Literature 1, an invention relating to an interlayer filling material for a touch panel characterized by containing polyvinyl acetal, a reactive diluent, and a photopolymerization initiator is disclosed, and it is described that a touch panel laminate that is excellent in conformability to difference in level and is less likely to suffer from cracks and damage is obtained.

### Citation List

### Patent Literature

PTL1: WO 2016/186029

### Summary of Invention

### Technical Problem

As described in Patent Literature 1, if a polyvinyl acetal resin is used as a material to bond an interlayer of a touch panel, impact absorption property is enhanced, and cracks and damage are less likely to occur. According to the studies by the present inventors, however, it has been found that if a polyvinyl acetal resin is used as an interlayer adhesive for a touch panel having a sensor glass, whitening is liable to occur on the periphery of the touch panel under the operating conditions of the touch panel (during voltage application) particularly when the temperature and the humidity are high. If whitening occurs, visibility of the touch panel is decreased, so that improvement is required.

Then, it is an object of the present invention to provide an interlayer adhesive comprising a polyvinyl acetal resin and capable of suppressing whitening, and a touch panel comprising the interlayer adhesive.

### Solution to Problem

The present inventors have earnestly studied, and as a result, they have found that the above problem can be solved by an interlayer adhesive comprising of a resin layer that comprises a polyvinyl acetal resin, wherein a content of alkali metal and alkaline earth metal contained in the resin layer is adjusted to a certain amount or less, and have completed the present invention.

The subject matter of the present invention is as follows.
[1] An interlayer adhesive comprising of a resin layer comprising a polyvinyl acetal resin, a content of alkali metal and alkaline earth metal contained in the resin layer being 15 ppm or less.
[2] The interlayer adhesive according to [1] above, wherein the alkali metal and the alkaline earth metal contained in the resin layer is at least one or more metals selected from the group consisting of Na, K, and Mg, and the amount of the metal is 10 ppm or less.
[3] The interlayer adhesive according to [1] or [2] above, wherein the resin layer comprises a phosphoric acid ester.
[4] The interlayer adhesive according to [3] above, wherein a concentration of the phosphoric acid ester in the resin layer is 0.1 mass% or more.
[5] The interlayer adhesive according to [4] above, wherein the concentration of the phosphoric acid ester in the resin layer is 0.5 mass% or less.
[6] The interlayer adhesive according to any one of [3] to [5] above, wherein HLB of the phosphoric acid ester is 10 or less.
[7] The interlayer adhesive according to any one of [3] to [6] above, wherein the phosphoric acid ester comprises a polyoxyalkylene alkyl ether group.
[8] The interlayer adhesive according to [7] above, wherein the polyoxyalkylene alkyl ether group is a compound represented by the formula (1): 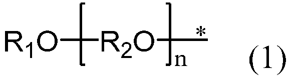 wherein R₁ is an alkyl group having 8 to 18 carbon atoms, R₂ is an alkylene group having 2 to 6 carbon atoms, n is 1 to 10, and * represents an atomic bond.
[9] The interlayer adhesive according to any one of [3] to [8] above, wherein the phosphoric acid ester is a compound represented by the formula (2) or the formula (3): 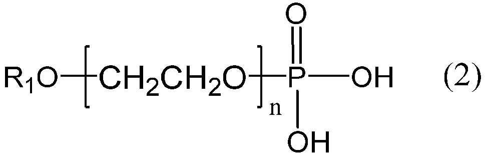 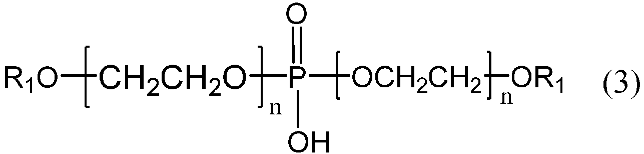 wherein R₁ is an alkyl group having 8 to 18 carbon atoms, and n is 1 to 10.
[10] The interlayer adhesive according to any one of [3] to [9] above, wherein the phosphoric acid ester comprises a dodecyl group.
[11] The interlayer adhesive according to any one of [1] to [10] above, wherein the polyvinyl acetal resin is a polyvinyl butyral resin.
[12] The interlayer adhesive according to any one of [1] to [11] above, wherein the resin layer comprises a plasticizer.
[13] An interlayer adhesive for a touch panel, consisting of the interlayer adhesive according to any one of [1] to [12] above.
[14] A touch panel comprising the interlayer adhesive according to any one of [1] to [12] above.

### Advantageous Effects of Invention

According to the present invention, an interlayer adhesive comprising a polyvinyl acetal resin and capable of suppressing whitening, and a touch panel comprising the interlayer adhesive can be provided.

### Brief Description of Drawings

[Fig. 1] Fig. 1 is a schematic sectional view showing one embodiment of the touch panel of the present invention.
[Fig. 2] Fig. 2 is a schematic sectional view showing another embodiment of the touch panel of the present invention.

### <Interlayer adhesive>

The interlayer adhesive of the present invention has a resin layer comprising a polyvinyl acetal resin, and a content of alkali metal and alkaline earth metal contained in the resin layer is 15 ppm or less.

### [Alkali metal and alkaline earth metal content]

In the resin layer in the present invention, the content of alkali metal and alkaline earth metal is 15 ppm or less. If the content of alkali metal and alkaline earth metal is more than 15 ppm, whitening of the periphery of a touch panel cannot be suppressed when the interlayer adhesive is used for lamination for the touch panel.

From the viewpoint of suppressing whitening more, the content of alkali metal and alkaline earth metal in the resin layer is preferably 10 ppm or less, more preferably 5 ppm or less, still more preferably 3 ppm or less.

The reason why whitening can be suppressed is not clear, but it is presumed that water tends to aggregate using alkali metal and alkaline earth metal as cores, and therefore, reduction of the amount of these metals can suppress aggregation of water.

From the viewpoint of suppressing whitening, the content of alkali metal and alkaline earth metal in the resin layer is ideally 0 ppm, but from the viewpoint of suppressing coloring of the resin layer, such as yellowing, it is preferably 0.1 ppm or more, more preferably 0.5 ppm or more.

The alkali metals refer to, among the Group 1 elements in the periodic table, Li (lithium), Na (sodium), K (potassium), Rb (rubidium), and Cs (cesium), and the alkaline earth metals refer to, among the Group 2 elements, Be (beryllium), Mg (magnesium), Ca (calcium), Sr (strontium), and Ba (barium).

The content of alkali metal and alkaline earth metal means a total content of alkali metals and alkaline earth metals in the resin layer. In the present description, the unit "ppm" of the content is based on mass, and means "mass ppm".

The content of alkali metal and alkaline earth metal can be adjusted to a desired value by adjusting the method for producing a polyvinyl acetal resin, or the types and the amounts of additives blended in the resin layer.

The alkali metal and the alkaline earth metal contained in the resin layer of the present invention is at least one or more metals selected from the group consisting of Na, K, and Mg, and the amount of the metal is preferably adjusted to 10 ppm or less, more preferably 5 ppm or less, still more preferably 3 ppm or less. The amount of the metal means a total amount of Na, K, and Mg.

By adjusting the amount of these specific alkali metal and alkaline earth metal to a certain level or less, whitening of the sensor glass can be more effectively suppressed.

Although the amount of the alkali metal and the alkaline earth metal in the resin layer will be described in Examples described later, it can be measured by the ICP atomic emission spectroscopy.

### <Phosphoric acid ester>

The resin layer of the present invention preferably contains a phosphoric acid ester. By adjusting the content of alkali metal and alkaline earth metal contained in the resin layer to a certain level or less as described above, and in addition, by further incorporating a phosphoric acid ester, whitening of the periphery of the touch panel is more effectively suppressed when the interlayer adhesive is used for lamination for the touch panel.
Although the reason for this is not clear, it is thought that the phosphoric acid ester tends to adsorb alkali metals and alkaline earth metals, and therefore, by incorporating the phosphoric acid ester while reducing the amount of the alkali metals and the alkaline earth metals, aggregation of water can be effectively suppressed.

The phosphoric acid ester is a compound having a phosphoric acid ester structure that is a structure wherein all or part of three hydrogen atoms of phosphoric acid (O=P(OH)₃) are substituted by organic groups, such as a phosphoric acid monoester, a phosphoric acid diester, or a phosphoric acid triester. In particular, a compound having a function of a surfactant having a hydrophilic moiety and a lipophilic moiety is preferable, and a phosphoric acid monoester or a phosphoric acid diester is preferable.

The HLB (Hydrophilic-Lipophilic Balance) of the phosphoric acid ester in the present invention is preferably 13 or less, more preferably 11 or less, still more preferably 10 or less, and is preferably 4 or more, more preferably 6 or more, from the viewpoint of suppressing whitening more.

The "HLB" in the present invention can be calculated from Griffin method [HLB = 20×(MW/MO), MW: sum total of formula weight of hydrophilic moieties, MO: molecular weight].

From the viewpoint that the HLB mentioned above is adjusted to a desired value and whitening is suppressed effectively, the phosphoric acid ester in the present invention preferably has a polyoxyalkylene alkyl ether group, and more specifically, it is preferably a compound having a polyoxyalkylene alkyl ether group and a phosphate backbone.

The polyoxyalkylene alkyl ether group is a group wherein polyoxyalkylene and an alkyl group are linked to each other with an ether linkage (-O-), and has a structure represented by the formula (1). 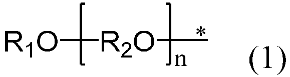 wherein R₁ is an alkyl group, R₂ is an alkylene group, n is 1 to 50, and * represents an atomic bond.

R₁ is preferably an alkyl group having 6 to 20 carbon atoms, more preferably an alkyl group having 8 to 18 carbon atoms, still more preferably an alkyl group having 10 to 14 carbon atoms. R₁ may be a straight-chain alkyl group, or may be a branched alkyl group, but from the viewpoint of suppressing whitening more, a straight-chain alkyl group is preferable.

Examples of R₁ include a hexyl group, an isohexyl group, a heptyl group, an isoheptyl group, an octyl group, a 2-ethylhexyl group, an isooctyl group, a nonyl group, an isononyl group, a decyl group, an isodecyl group, an undecyl group, an isoundecyl group, a dodecyl group, an isododecyl group, a tridecyl group, an isotridecyl group, a tetradecyl group, an isotetradecyl group, a pentadecyl group, an isopentadecyl group, a hexadecyl group, an isohexadecyl group, a 2-hexyldecyl group, a heptadecyl group, an isoheptadecyl group, an octadecyl group, an isooctadecyl group, a 2-octyldecyl group, a 2-hexyldodecyl group, a nonadecyl group, an isononadecyl group, an eicosyl group, and an isoeicosyl group.

Among these, a dodecyl group or an isotridecyl group is preferable, and a dodecyl group is more preferable, as R₁. That is to say, from the viewpoint that the HLB is adjusted to a desired range and whitening is suppressed more, the phosphoric acid ester is preferably one having a dodecyl group or an isotridecyl group, and is more preferably one having a dodecyl group.

In the above formula (1), R₂ is an alkylene group, preferably an alkylene group having 2 to 6 carbon atoms, more preferably an alkylene group having 2 to 3 carbon atoms, still more preferably an alkylene group having 2 carbon atoms (that is, an ethylene group). In the case where n is 2 or more, a plurality of R₂ may be the same or may be different.

n is 1 to 50, preferably 1 to 30, more preferably 1 to 10.

In the formula (1), * represents an atomic bond, and * is preferably an atomic bond bonded to a phosphorus atom of a phosphate backbone.

In the present invention, the phosphoric acid ester is preferably a compound represented by the following formula (2) or formula (3), and is more preferably a compound represented by the formula (2). The phosphoric acid ester in the present invention may be a mixture of compounds represented by the formula (2) and the formula (3). 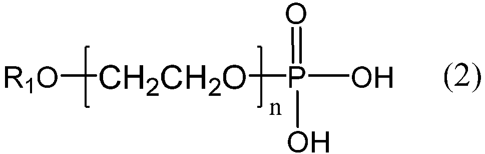 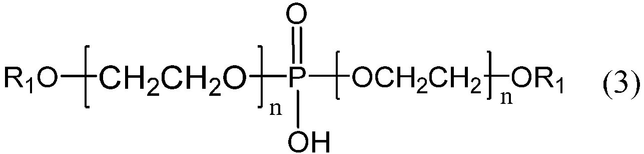 In the formula (2) and the formula (3), R₁ and n have the same meanings as those in the formula (1).

From the viewpoint of suppressing whitening more, the content of the phosphoric acid ester in the resin layer is preferably 0.04 mass% or more, more preferably 0.1 mass% or more, and from the viewpoint of heat yellowing resistance, it is preferably 0.5 mass% or less, more preferably 0.3 mass% or less.

### [Polyvinyl acetal resin]

The resin layer of the present invention contains a polyvinyl acetal resin. By containing the polyvinyl acetal resin, adhesion between members for constituting a touch panel, such as a cover glass and a sensor glass, can be enhanced, and impact absorption property is enhanced, so that cracks and damage are less likely to occur.

The polyvinyl acetal resin is obtained by acetalizing polyvinyl alcohol (PVA) with an aldehyde. That is to say, the polyvinyl alcohol resin is preferably an acetalization product of polyvinyl alcohol (PVA). The polyvinyl alcohol (PVA) is obtained by, for example, saponifying a polyvinyl ester such as polyvinyl acetate. The degree of saponification of the polyvinyl alcohol is generally 70 to 99.9 mol%. The polyvinyl acetal resin may be used singly, or may be used in combination of two or more.

The average degree of polymerization of the polyvinyl acetal resin is preferably 200 or more, more preferably 500 or more, still more preferably 1000 or more, even more preferably 1500 or more. The average degree of polymerization of the polyvinyl acetal resin is preferably 5000 or less, more preferably 4000 or less, still more preferably 3500 or less.

The average degree of polymerization of the polyvinyl acetal resin is the same as the average degree of polymerization of PVA that becomes a raw material of the polyvinyl acetal resin, and the average degree of polymerization of PVA is determined by the method in accordance with JIS K6726 "Testing methods for polyvinyl alcohol".

The aldehyde used in the acetalization is not particularly limited, but an aldehyde having 1 to 10 carbon atoms is preferably used, and an aldehyde having 3 to 5 carbon atoms is more preferable, an aldehyde having 4 or 5 carbon atoms is still more preferable, and an aldehyde having 4 carbon atoms is particularly preferable.

The aldehyde having 1 to 10 carbon atoms is not particularly limited, and examples thereof include formaldehyde, acetaldehyde, propionaldehyde, n-butyraldehyde, isobutyraldehyde, n-valeraldehyde, 2-ethylbutyraldehyde, n-hexyl aldehyde, n-octyl aldehyde, n-nonyl aldehyde, n-decyl aldehyde, and benzaldehyde. Among these, preferable is acetaldehyde, propionaldehyde, n-butyraldehyde, isobutyraldehyde, n-hexyl aldehyde, or n-valeraldehyde; more preferable is propionaldehyde, n-butyraldehyde, isobutyraldehyde, or n-valeraldehyde; still more preferable is n-butyraldehyde, or n-valeraldehyde; and most preferable is n-butyraldehyde. Only one of the above aldehydes may be used, or two or more of them may be used in combination.

The number of carbon atoms of an acetal group contained in the polyvinyl acetal resin is not particularly limited, but it is preferably 1 to 10, more preferably 3 to 5, still more preferably 4 or 5, particularly preferably 4. Specifically, a butyral group is particularly preferable as the acetal group, and therefore, a polyvinyl butyral resin is preferable as the polyvinyl acetal resin.

The amount of hydroxyl groups in the polyvinyl acetal resin is preferably 15 mol% or more, and is preferably 38 mol% or less. By adjusting the amount of hydroxyl groups to 15 mol% or more, adhesion tends to be enhanced. By adjusting the amount of hydroxyl groups to 38 mol% or less, the resin layer is prevented from becoming too hard. From the viewpoint of adhesion, etc., the amount of hydroxyl groups is more preferably 20 mol% or more, still more preferably 25 mol% or more. The amount of hydroxyl groups is more preferably 35% or less, still more preferably 33 mol% or less.

When a polyvinyl butyral resin is used as the polyvinyl acetal resin, the amount of hydroxyl groups is, from the same viewpoint, 15 mol% or more, and is preferably 38 mol% or less; and it is more preferably 20 mol% or more, still more preferably 25 mol% or more, and is more preferably 35 mol% or less, still more preferably 33 mol% or less.

The amount of hydroxyl groups in the polyvinyl acetal resin is a value of a molar fraction expressed as a percentage, the molar fraction being determined by dividing the amount of ethylene groups to which hydroxyl groups are bonded by the amount of all ethylene groups of main chains. The amount of ethylene groups to which hydroxyl groups are bonded can be measured in accordance with, for example, JIS K6728 "Testing methods for polyvinyl butyral".

The degree of acetalization of the polyvinyl acetal resin is preferably 47 mol% or more, and is preferably 85 mol% or less. The degree of acetalization is more preferably 55 mol% or more, still more preferably 60 mol% or more, and is more preferably 80 mol% or less, still more preferably 75 mol% or less.

When the acetal group is a butyral group and the polyvinyl acetal resin is a polyvinyl butyral resin, the degree of acetalization means a degree of butyralization.

The degree of acetalization is a value of a molar fraction expressed as a percentage, the molar fraction being determined by dividing a value, which is obtained by subtracting the amount of ethylene groups to which hydroxyl groups are bonded and the amount of ethylene groups to which acetyl groups are bonded from the amount of all ethylene groups of main chains, by the amount of all ethylene groups of main chains. The degree of acetalization (degree of butyralization) may be calculated from the results measured by, for example, the method in accordance with JIS K6728 "Testing methods for polyvinyl butyral".

The degree of acetylation of the polyvinyl acetal resin is preferably 30 mol% or less, more preferably 20 mol% or less, still more preferably 10 mol% or less, even more preferably 2 mol% or less. When the degree of acetylation is the above-mentioned upper limit or less, moisture resistance of the resin layer is increased. The degree of acetylation is not particularly limited, but it is preferably 0.01 mol% or more, more preferably 0.1 mol% or more.

The degree of acetylation is a value of a molar fraction expressed as a percentage, the molar fraction being determined by dividing the amount of ethylene groups to which acetyl groups are bonded by the amount of all ethylene groups of main chains. The amount of ethylene groups to which acetyl groups are bonded can be measured in accordance with, for example, JIS K6728 "Testing methods for polyvinyl butyral".

### [Method for producing polyvinyl acetal resin]

The polyvinyl acetal resin is obtained by acetalizing polyvinyl alcohol (PVA) with an aldehyde, as previously described. The acetalization is usually carried out in the presence of an acid catalyst. Examples of the acid catalysts include inorganic acids, such as hydrochloric acid, sulfuric acid, and nitric acid, and organic acids, such as acetic acid, benzoic acid, para-toluenesulfonic acid, uric acid, and barbituric acid. These acids may be used singly, or may be used in combination of two or more.

If the acid catalyst remains in the polyvinyl acetal resin, it causes discoloration such as yellowing, and therefore, it is preferable to perform neutralization with a neutralizer. Examples of the neutralizers include sodium hydroxide, sodium carbonate, sodium bicarbonate, potassium hydroxide, potassium carbonate, and potassium bicarbonate, and among these, sodium bicarbonate or potassium bicarbonate is preferable. As the neutralizer, a compound containing an alkali metal is generally used, as described above. On that account, from the viewpoint of adjusting the content of alkali metal and alkaline earth metal in the resin layer to a certain level or less, the amount of the neutralizer used is preferably kept as small as possible.

The amount of the neutralizer used based on the polyvinyl acetal resin is preferably 0.1 to 5 mass%, more preferably 0.3 to 3 mass%, still more preferably 0.5 to 1.5 mass%, based on 100 mass% of the polyvinyl acetal resin.

### [Other resins]

The resin layer may further contain resins other than the polyvinyl acetal resin within the range not inhibiting the effects of the present invention. Examples of the resins other than the polyvinyl acetal resin include an ethylene-vinyl acetate copolymer resin, an ionomer resin, a polyurethane resin, a thermoplastic elastomer, and an acrylic resin. The content of the polyvinyl acetal resin is, based on the total amount of resins contained in the resin layer, preferably 50 mass% or more, more preferably 80 mass% or more, still more preferably 100 mass%.

### [Plasticizer]

The resin layer of the present invention preferably contains a plasticizer. By incorporating a plasticizer in the resin layer together with the above-mentioned polyvinyl acetal resin, impact absorption property can be enhanced more. Further, since the resin layer contains a plasticizer, the resin layer becomes more flexible and is easily adjusted to a prescribed shape.

Examples of the plasticizers include organic ester plasticizers, organophosphorus-based plasticizers such as organophosphoric acid ester plasticizers and organophosphorous acid ester plasticizers, polyalkylene glycol-based plasticizers, organic ether-based plasticizers such as polyoxyalkylene ether-based plasticizers, and alcohol-based plasticizers. The plasticizers may be used singly, or may be used in combination of two or more. Ampong those mentioned above, organic ester plasticizers and polyalkylene glycol-based plasticizers are preferable, and among them, organic ester plasticizers are more preferable. Examples of preferred organic ester plasticizers include a monobasic organic acid ester and a polybasic organic acid ester.

As the monobasic organic acid ester, an ester of a glycol and a monobasic organic acid can be mentioned. The glycol is, for example, a polyalkylene glycol wherein each alkylene unit has 2 to 4 carbon atoms, preferably 2 or 3 carbon atoms, and the number of alkylene repeating units is 2 to 10, preferably 2 to 4. The glycol may be a monoalkylene glycol having 2 to 4 carbon atoms, preferably 2 or 3 carbon atoms (that is, one repeating unit).

Specific examples of the glycols include ethylene glycol, diethylene glycol, triethylene glycol, tetraethylene glycol, propylene glycol, dipropylene glycol, tripropylene glycol, tetrapropylene glycol, and butylene glycol.

As the monobasic organic acid, an organic acid having 3 to 10 carbon atoms can be mentioned, and specific examples thereof include butyric acid, isobutyric acid, caproic acid, 2-ethylbutyric acid, heptylic acid, n-octylic acid, 2-ethylhexylic acid, n-nonylic acid, and decylic acid.

Specific examples of the monobasic organic acid esters include triethylene glycol di-2-ethylbutyrate, triethylene glycol di-2-ethylhexanoate, triethylene glycol dicaprylate, triethylene glycol di-n-octanoate, triethylene glycol di-n-heptanoate, tetraethylene glycol di-n-heptanoate, tetraethylene glycol di-2-ethylhexanoate, diethylene glycol di-2-ethylbutyrate, diethylene glycol di-2-ethylhexanoate, dipropylene glycol di-2-ethylbutyrate, triethylene glycol di-2-ethylpentanoate, tetraethylene glycol di-2-ethylbutyrate, diethylene glycol dicapriate, triethylene glycol di-n-heptanoate, tetraethylene glycol di-n-heptanoate, triethylene glycol di-2-ethylbutyrate, ethylene glycol di-2-ethylbutyrate, 1,2-propylene glycol di-2-ethylbutyrate, 1,3-propylene glycol di-2-ethylbutyrate, 1,4-butylene glycol di-2-ethylbutyrate, and 1,2-butylene glycol di-2-ethylbutyrate.

Examples of the polybasic organic acid esters include ester compounds of dibasic organic acids having 4 to 12 carbon atoms, such as adipic acid, sebacic acid, azelaic acid, and phthalic acid, and alcohols having 4 to 10 carbon atoms. The alcohols having 4 to 10 carbon atoms may be straight-chain, or may have a branched structure, or may have a cyclic structure.

Specific examples thereof include dibutyl sebacate, dioctyl azelate, dihexyl adipate, dioctyl adipate, hexyl cyclohexyl adipate, hexyl cyclohexyl adipate, diisononyl adipate, heptyl nonyl adipate, dibutyl carbitol adipate, a mixed adipic acid ester, dioctyl phthalate, and dibutyl phthalate. An oil-modified sebacic acid alkyd or the like is also available. As the mixed adipic acid ester, an adipic acid ester prepared from two or more alcohols selected from the group consisting of alkyl alcohols having 4 to 9 carbon atoms and cyclic alcohols having 4 to 9 carbon atoms can be mentioned.

The organic ester plasticizer is not limited to a complete ester of the above-mentioned each ester, and may be a partial ester. For example, it may be a partial ester of a glycol and a monobasic organic acid, or may be a partial ester of a dibasic organic acid and an alcohol. Specifically, triethylene glycol mono-2-ethylhxanoate, etc. can be mentioned.

Moreover, it may be a partial ester of a trihydric or higher alcohol such as glycerol and a monobasic organic acid. The monobasic organic acid is, for example, a monobasic organic acid having 3 to 24 carbon atoms, preferably 6 to 18 carbon atoms. Specific examples of the partial esters of trihydric or higher alcohols and monobasic organic acids include a mono- or diester of glycerol and stearic acid and a mono- or diester of glycerol and 2-ethylhexylic acid.

As the organic ester plasticizer, triethylene glycol di-2-ethylhexanoate (3GO) or dioctyl adipate (DOA) is particularly preferably used among those mentioned above.

Examples of the organophosphorus-based plasticizers include phosphoric acid esters, such as tributoxyethyl phosphate, isodecyl diphenyl phosphate, and triisopropyl phosphate.

Examples of the polyalkylene glycol-based plasticizers include polyethylene glycol, polypropylene glycol, a poly(ethylene oxide/propylene oxide) block copolymer, a poly(ethylene oxide/propylene oxide) random copolymer, and polytetramethylene glycol, and among these, polypropylene glycol is preferable.

The polyoxyalkylene ether-based plasticizer is an ether compound of a monohydric or polyhydric alcohol and polyoxyalkylene.

Specific examples of the polyoxyalkylene ether-based plasticizers include polyoxyethylene hexyl ether, polyoxyethylene heptyl ether, polyoxyethylene octyl ether, polyoxyethylene 2-ethylhexyl ether, polyoxyethylene nonyl ether, polyoxyethylene decyl ether, polyoxyethylene allyl ether, polyoxypropylene allyl ether, polyoxyethylene glyceryl ether, polyoxypropylene glyceryl ether, polyoxyethylene diglyceryl ether, polyoxypropylene diglyceryl ether, polyoxyalkylene pentaerythritol ether, and polycaprolactone triol.

The polyoxyalkylene ether-based plasticizer is preferably an ether compound of a polyhydric alcohol and polyoxyalkylene, more preferably an ether compound of glycerol or diglycerol and polyoxyalkylene, still more preferably an ether compound of glycerol or diglycerol and polyoxypropylene.

Examples of the alcohol-based plasticizers include alcohols other than the polyalkylene glycol plasticizers and the polyoxyalkylene ether plasticizers. Specific examples thereof include various polyhydric alcohols, such as ethylene glycol, propylene glycol, butanediol, hexanediol, trimethylolpropane, pentaerythritol, glycerol, and diglycerol. Among these, ethylene glycol is preferable.

The content of the plasticizer in the resin layer is, based on 100 parts by mass of the polyacetal resin, preferably 5 parts by mass or more, more preferably 15 parts by mass or more, still more preferably 30 parts by mass or more, and is preferably 100 parts by mass or less, more preferably 60 parts by mass or less, still more preferably 50 parts by mass or less.

### [Adhesive force controller]

The resin layer in the present invention may contain an adhesive force controller from the viewpoint of enhancement in adhesive force. As the adhesive force controller, however, a compound containing an alkali metal or an alkaline earth metal is generally used, and therefore, the amount of the adhesive force controller used is preferably reduced as much as possible from the viewpoint that the content of alkali metal and alkaline earth metal contained in the resin layer is adjusted to a certain level or less.

When the adhesive force controller is used, the content thereof may be such an amount that the content of alkali metal and alkaline earth metal in the resin layer containing polyvinyl acetal becomes 15 ppm or less, preferably becomes 10 ppm or less, more preferably becomes 5 ppm or less, still more preferably becomes 3 ppm or less.

In the present invention, it is preferable that the resin layer should not contain the adhesive force controller.

As the adhesive force controller, a metal salt of an organic acid such as carboxylic acid, or the like can be mentioned. The organic acid is, for example, carboxylic acid having 2 to 10 carbon atoms, and examples of the metal salts include a potassium salt, a sodium salt, and a magnesium salt. Specific examples of the adhesive force controllers include magnesium acetate, magnesium propionate, magnesium 2-ethylbutanoate, and magnesium 2-ethylhexanoate.

### [Other additives]

The resin layer of the present invention may contain known additives, such as a tackifier resin, an emulsifier, a softener, fine particles, a filler, a pigment, a dye, a silane coupling agent, an antioxidant, a surfactant, and a wax, when needed.

### (Film shape)

The interlayer adhesive of the present invention preferably has a film shape from the viewpoint that it can be easily attached to a base material. In this case, the interlayer adhesive of the present invention may be obtained by, for example, mixing the resin, the phosphoric acid ester, and various additives that are blended as needed, and forming the resulting resin composition by extrusion forming, press forming, or the like.

### [Thickness]

The thickness of the interlayer adhesive of the present invention is not particularly limited, and may be appropriately adjusted according to the size and the type of a touch panel to be used. The thickness of the interlayer adhesive is preferably 0.05 mm or more, more preferably 0.1 mm or more, still more preferably 0.15 mm or more, and is preferably 5 mm or less, more preferably 3 mm or less, still more preferably 1 mm or less.

### [Touch panel]

The interlayer adhesive of the present invention can be preferably used for bonding members for constituting a touch panel. Moreover, by the present invention, a touch panel comprising an interlayer adhesive can be provided.

An interlayer adhesive for a touch panel, which uses such an interlayer adhesive of the present invention, is also one of the present inventions.

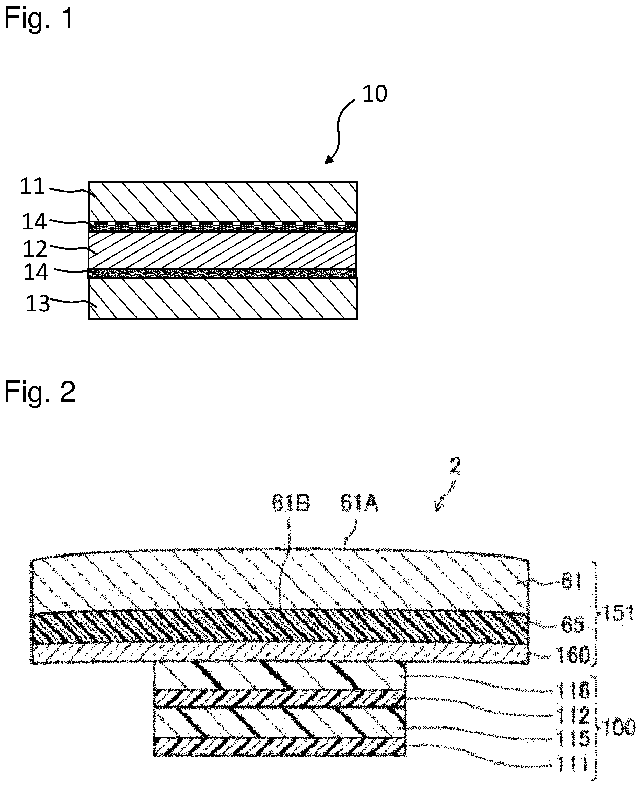

Fig. 1 shows one embodiment of the touch panel of the present invention. The present invention is not limited to the contents of the drawing.

A touch panel 10 shown in Fig. 1 has a cover glass 11, a sensor glass 12, and a liquid crystal panel 13 in this order. The cover glass 11 is a member having light transmission property, and its surface becomes an operation surface with which the user's fingers, etc. come into contact by a touch operation. The sensor glass 12 has an ITO pattern (not shown) formed on its surface, and this enables detection of the touch operation by the user's fingers (object to be detected). The sensor glass 12 may have a single layer structure or may have a multilayer structure. A prescribed image can be displayed by the liquid crystal panel 13. Instead of the liquid crystal panel 13, an organic EL panel can also be used.

Between the cover glass 11 and the sensor glass 12, the interlayer adhesive 14 of the present invention is provided, and it bonds the cover glass 11 and the sensor glass 12 together and fixes them. Since the interlayer adhesive 14 uses a polyvinyl acetal resin, adhesion between the cover glass 11 and the sensor glass 12 is good, and in addition, impact absorption property is enhanced, so that cracks and damage are less likely to occur.

In the resin layer to form the interlayer adhesive 14, the content of alkali metal and alkaline earth metal is adjusted to a certain level or less, and therefore, whitening can be suppressed under the operating conditions of the touch panel (during voltage application) even in the case where the temperature and the humidity are high.

As shown in Fig. 1, the interlayer adhesive 14 of the present invention can be used between the sensor glass 12 and the liquid crystal panel 13, when needed, but an optical adhesive (OCA) generally used, or the like may be used.

In Fig. 1, a touch panel constituted of a cover glass 11, a sensor glass 12, a liquid crystal panel 13, and an interlayer adhesive 14 is shown, but the touch panel may be a touch panel further having a structure other than these.

As shown in Fig. 2, a touch panel 2 may have a touch panel main body 100 and a cover member 151.

The cover member 151 has a first member 61 made of a glass plate, an interlayer adhesive 65, and a second member 160. The interlayer adhesive 65 has an almost uniform thickness and is arranged in close contact with a second face 61B. The second member 160 is arranged in close contact with the interlayer adhesive 65 along the outer surface of the interlayer adhesive 65. The second member 160 is disposed to follow the outer surface of the interlayer adhesive 65.

The first member 61 has a first face 61A and a second face 61B that is on the side opposite to the first face 61A. A so-called operation surface is a first face 61A. On the whole surface of the second face 61B, the interlayer adhesive 65 having transparency is arranged.

The material of the first member 61 is, for example, a glass plate, and may be a sheet glass having flexibility. As the first member 61, a glass plate having a thickness of 0.01 mm or more and 0.55 mm or less is preferably used from the viewpoint of lightweight property, etc. For constructing a cover member 151 having a size of 25 inches or more, it is preferable to use a glass plate having a thickness of 0.01 mm or more and 1.85 mm or less.

When a glass plate having a thickness of 0.7 mm or less is used, a cover member 151 having a thin thickness can be constructed. In the case of a cover member 151 corresponding to a touch panel main body 100 compatible with a large screen of a size of 25 inches or more, it is desirable to use a thick glass plate as the first member 61 so as not to make large deflection, but from the viewpoint of the overall thickness, the thickness of the first member 61 is desirably 2.5 mm or less.

The material of the second member 160 is, for example, a glass plate, and may be a sheet glass having flexibility. From the viewpoint of lightweight property, etc., it is preferable to use a glass plate having a thickness of 0.01 mm or more and 0.55 mm or less as the second member 160. For constructing a cover member 151 having a size of 25 inches or more, it is preferable to use a glass plate having a thickness of 0.01 mm or more and 1.85 mm or less. The glass plate having this thickness can be easily disposed, as the second member 160, to follow the outer surface of the interlayer adhesive 65, and in addition, biting in of air bubbles and the like can be suppressed.

The cover member 151 is constructed by arranging the first member 61 made of a glass plate and the second member 160 made of a glass plate so as to sandwich the interlayer adhesive 65 therebetween.

On the outer surface of the second member 160, a touch panel main body 100 is mounted. In Fig. 2, a touch panel main body 100 having a structure in which two substrates are laminated is shown. To briefly describe the touch panel main body 100, the touch panel main body 100 has a first substrate 111 and a second substrate 112. The first substrate 111 and the second substrate 112 each have transparency, and are each made of, for example, a resin film or a glass plate. On the first substrate 111, a transmitting electrode of a sensor electrode is arranged, and on the second substrate 112, a receiving electrode of a sensor electrode is arranged. The first substrate 111 and the second substrate 112 are laminated to each other with a transparent pressure-sensitive adhesive 115. On the second substrate 112, a transparent pressure-sensitive adhesive 116 for use in adhesion to the cover member 151 is provided. The touch panel main body 100 is mounted on the outer surface of the second member 160 through the pressure-sensitive adhesive 116. As the pressure-sensitive adhesive 115 and the pressure-sensitive adhesive 116, the interlayer adhesive according to the present invention can be used, but an optical adhesive (OCA) generally used, or the like may be used.

The method for producing the touch panel of the present invention is not particularly limited, but it is preferable to produce it by a vacuum packing method. For example, the interlayer adhesive is introduced into part or all of spaces between the members for constituting the touch panel, the members are placed in a vacuum pack, then vacuum suction is performed, and thereafter, the members are preliminarily bonded at about 70 to 110°C to obtain a laminated body. Next, the laminated body is compression bonded at about 120 to 150°C and at a pressure of 1 to 1.5 MPa by placing it in an autoclave or pressing it. Thus, a touch panel can be obtained.

### Examples

The present invention will be described in more detail with reference to Examples, but the present invention is in no way limited to these Examples.

Measurement and evaluation of various properties were carried out in the following manner.

### [Content of alkali metal and alkaline earth metal]

The total content of alkali metal and alkaline earth metal contained in the resin layer was quantified by the ICP atomic emission spectrometry. For the ICP atomic emission spectrometry, a sample was thermally decomposed with sulfuric acid and nitric acid, this decomposition product was diluted to a determined volume with ultrapure water, and thereafter, the ICP-AES method was conducted using an ICP-AES atomic emission spectrometer (ICAP-575 model manufactured by Nippon Jarrell-Ash Co., Ltd.).

### [Whitening distance due to moisture and heat resistance test]

The cover glass laminate prepared in each of Examples and Comparative Examples was maintained at a temperature of 60°C and a relative humidity of 90% while a voltage (5 V) was applied thereto by a function generator, and after the lapse of 1000 hours, a whitening distance was measured. The whitening distance was determined by measuring a distance of a whitened portion from the edge of the cover glass laminate, and was evaluated by the following criteria.

### (Evaluation criteria)

AA: The whitening distance is 1.5 mm or less.
A: The whitening distance is more than 1.5 mm and 3 mm or less.
C: The whitening distance is more than 3 mm.

The plasticizer, the phosphoric acid ester, and the adhesive force controller used in Examples and Comparative Examples are as follows.

### <Plasticizer>

3GO: Triethylene glycol di-2-ethylhexanoate

### <Phosphoric acid ester>

"PLYSURF A208B" manufactured by DKS Co., Ltd., compound of the formula (2) wherein R1 is a dodecyl group, and n is 2. HLB=8.

### <Adhesive force controller>

Magnesium acetate aqueous solution (Mg concentration 3.65 wt%)

### [Example 1]

### (Production of polyvinyl butyral resin)

In a reactor equipped with a stirring device, 1800 g of ion-exchanged water and 200 g of polyvinyl alcohol A (average degree of polymerization 1700, degree of saponification 99 mol%) were placed, and heated to dissolve the polyvinyl alcohol A with stirring, thereby obtaining a polyvinyl alcohol solution. Next, to this solution, 25% hydrochloric acid was added as a catalyst so that the hydrochloric acid concentration became 0.2 mass%, and after the temperature was adjusted to 15°C, 16 g of n-butyraldehyde was added with stirring. Thereafter, 95 g of n-butyraldehyde was added, and as a result, a white particulate polyvinyl butyral resin was precipitated. 10 minutes after the precipitation, 25% hydrochloric acid was added so that the concentration became 1.8 wt%, and were heated to 63°C and held for 2 hours. Thereafter, the solution was cooled and washed with excess water to wash away unreacted butyraldehyde.

Subsequently, to a reactor equipped with a stirring device, the polyvinyl butyral resin obtained above and ion-exchanged water were added so that the slurry concentration became 10 wt%. Further, sodium bicarbonate that was a general-purpose neutralizer was added in an amount of 1 mass% based on the polyvinyl butyral resin, and heated to 80°C to neutralize the hydrochloric acid catalyst, and after the resulting mixture was cooled, it was washed with excess water and dried to obtain a polyvinyl butyral resin. The amount of hydroxyl groups in the resulting polyvinyl butyral resin was 30.6 mol%, the degree of acetalization was 68.7 mol%, and the degree of acetylation was 0.7 mol%.

### (Production of interlayer adhesive)

100 Parts by mass of the above polyvinyl butyral resin and 35 parts by mass of 3GO as a plasticizer were mixed, and this was sufficiently melt-kneaded by a mixing roll and then press-formed by a press forming machine at 150°C for 10 minutes, thereby obtaining an interlayer adhesive having a thickness of 0.4 mm.

### (Evaluation)

A cover glass (soda glass manufactured by Nippon Sheet Glass Company Ltd.) and a sensor glass having an ITO pattern formed thereon (manufactured by Techno Print Co., Ltd., ITO thickness 150 nm, resistance value around 10 Ω/□) were prepared.

The interlayer adhesive prepared as above was sandwiched between the sensor glass and the cover glass to obtain a laminated body. This laminated body was placed in a rubber bag, and the rubber bag was degassed at a degree of vacuum of 1.0 MPa for 10 minutes and then transferred into an oven having been adjusted to a temperature of 100°C, while being degassed, and further, the laminated body was temporarily compression-bonded until a temperature of 85°C was reached. In an autoclave, the laminated body having been temporarily compression-bonded was compression-bonded for 20 minutes under the conditions of 140°C and a pressure of 1.3 MPa, thereby obtaining a cover glass laminate wherein the cover glass, the resin layer (interlayer adhesive for touch panel), and the sensor glass were laminated in this order.

The amount of alkali metals and alkaline earth metals in the resin layer of the cover glass laminate was evaluated as described above. Moreover, the whitening distance of the cover glass laminate was measured as described above. The results are set forth in Table 1.

### [Example 2]

The same procedure as in Example 1 was carried out except that the type of the neutralizer was changed to potassium bicarbonate from sodium bicarbonate in Production of polyvinyl butyral resin in Example 1.

### [Example 3]

The same procedure as in Example 1 was carried out except that a magnesium acetate aqueous solution that was an adhesive force controller was added in an amount of 0.018 part by mass based on 100 parts by mass of the polyvinyl butyral resin in Production of interlayer adhesive in Example 1.

### [Example 4]

The same procedure as in Example 1 was carried out except that PLYSURF A208B that was a phosphoric acid ester was added in an amount of 0.14 part by mass based on 100 parts by mass of the polyvinyl butyral resin in Production of interlayer adhesive in Example 1.

### [Comparative Example 1]

The same procedure as in Example 1 was carried out except that the amount of the neutralizer was changed to 10 times the equivalent (that is, 10 mass% based on the polyvinyl butyral resin) in Production of polyvinyl butyral resin in Example 1.

### [Comparative Example 2]

The same procedure as in Example 2 was carried out except that the amount of the neutralizer was changed to 10 times the equivalent (that is, 10 mass% based on the polyvinyl butyral resin) in Production of polyvinyl butyral resin in Example 2.

### [Comparative Example 3]

The same procedure as in Example 3 was carried out except that the amount of the magnesium acetate aqueous solution that was an adhesive force controller was changed to 3 times (that is, 0.054 part by mass based on 100 parts by mass of the polyvinyl butyral resin) in Production of interlayer adhesive in Example 3.

**Table 1**

| | | | Example 1 | Example 2 | Example 3 | Example 4 | Comparative Example 1 | Comparative Example 2 | Comparative Example 3 |
|---|---|---|---|---|---|---|---|---|---|
| | Resin | Type | PVB | PVB | PVB | PVB | PVB | PVB | PVB |
| | | Part(s) | 100 | 100 | 100 | 100 | 100 | 100 | 100 |
| | Plasticizer | Type | 3GO | 3GO | 3GO | 3GO | 3GO | 3GO | 3GO |
| | | Part(s) | 35 | 35 | 35 | 35 | 35 | 35 | 35 |
| | Phosphoric acid ester | Type | None | None | None | PLYSURF | None | None | None |
| | | Concentration | - | - | - | 0.1 wt% | - | - | - |
| Resin layer composition | Adhesive force controller | Type | None | None | Magnesium acetate aqueous solution | None | None | None | Magnesium acetate aqueous solution |
| | | Part(s) | - | - | 0.018 | - | - | - | 0.054 |
| | Alkali metal | Type | Na | K | Na | Na | Na | K | Na |
| | | Concentration | 3 ppm | 5 ppm | 5 ppm | 5 ppm | 17 ppm | 28 ppm | 5 ppm |
| | Alkaline earth metal | Type | - | - | Mg | - | - | - | Mg |
| | | Concentration | - | - | 3 ppm | - | - | - | 16 ppm |
| | Total of alkali metals and alkaline earth metals | Concentration | 6 ppm | 7 ppm | 11 ppm | 7 ppm | 21 ppm | 29 ppm | 22 ppm |
| Moisture and heat resistance test (with voltage applied) | | Whitening distance | A | A | A | AA | C | C | C |

| | | | | | | | | | |
|---|---|---|---|---|---|---|---|---|---|
| * In Table 1, PVB, the plasticizer, and the adhesive force controller represent part(s) by mass. The content of the phosphoric acid ester represents mass% thereof in the resin layer. | | | | | | | | | |

By using the interlayer adhesive of each of Examples in which the amount of alkali metals and alkaline earth metals was small, whitening of the touch panel in the moisture and heat resistance test was able to be suppressed.

In contrast therewith, the interlayer adhesive of each of Comparative Examples contained large amounts of alkali metals and alkaline earth metals and was not able to suppress whitening of the touch panel in the moisture and heat resistance test.

### Reference Signs List

2, 10 touch panel
11 cover glass
12 sensor glass
13 liquid crystal panel
14 interlayer adhesive
61 first member
65 interlayer adhesive
100 touch panel main body
111 first substrate
112 second substrate
115, 116 pressure-sensitive adhesive
151 cover member
160 second member

## Claims

1. An interlayer adhesive comprising of a resin layer comprising a polyvinyl acetal resin, a content of alkali metal and alkaline earth metal contained in the resin layer being 15 ppm or less.

2. The interlayer adhesive according to claim 1, wherein the alkali metal and the alkaline earth metal contained in the resin layer is at least one or more metals selected from the group consisting of Na, K, and Mg, and the amount of the metal is 10 ppm or less.

3. The interlayer adhesive according to claim 1 or 2, wherein the resin layer comprises a phosphoric acid ester.

4. The interlayer adhesive according to claim 3, wherein a concentration of the phosphoric acid ester in the resin layer is 0.1 mass% or more.

5. The interlayer adhesive according to claim 4, wherein the concentration of the phosphoric acid ester in the resin layer is 0.5 mass% or less.

6. The interlayer adhesive according to any one of claims 3 to 5, wherein HLB of the phosphoric acid ester is 10 or less.

7. The interlayer adhesive according to any one of claims 3 to 6, wherein the phosphoric acid ester comprises a polyoxyalkylene alkyl ether group.

8. The interlayer adhesive according to claim 7, wherein the polyoxyalkylene alkyl ether group is a compound represented by the formula (1): 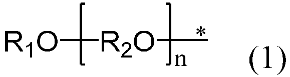 wherein R₁ is an alkyl group having 8 to 18 carbon atoms, R₂ is an alkylene group having 2 to 6 carbon atoms, n is 1 to 10, and * represents an atomic bond.

9. The interlayer adhesive according to any one of claims 3 to 8, wherein the phosphoric acid ester is a compound represented by the formula (2) or the formula (3): 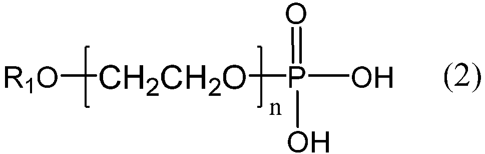 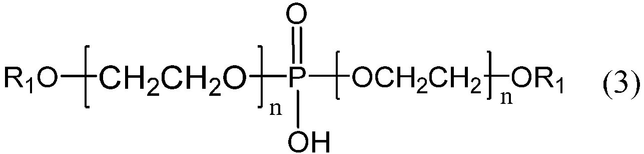 wherein R₁ is an alkyl group having 8 to 18 carbon atoms, and n is 1 to 10.

10. The interlayer adhesive according to any one of claims 3 to 9, wherein the phosphoric acid ester comprises a dodecyl group.

11. The interlayer adhesive according to any one of claims 1 to 10, wherein the polyvinyl acetal resin is a polyvinyl butyral resin.

12. The interlayer adhesive according to any one of claims 1 to 11, wherein the resin layer comprises a plasticizer.

13. An interlayer adhesive for a touch panel, consisting of the interlayer adhesive according to any one of claims 1 to 12.

14. A touch panel comprising the interlayer adhesive according to any one of claims 1 to 12.
